# EUROPÄISCHE PATENTSCHRIFT

(11) **EP 3 694 679 B1**
(45) Veröffentlichungstag und Bekanntmachung des Hinweises auf die Patenterteilung: **31.03.2021**
(21) Anmeldenummer: 18759068.2
(22) Anmeldetag: 15.08.2018
(51) Int. Cl.: B23K 20/06, B23K 20/22, B21D 26/14, H01R 4/62, H01R 43/02, B23K 101/32, B23K 101/38, B23K 103/16

(54) **VERFAHREN ZUM ERSTELLEN EINER SCHIRMANBINDUNG EINES GESCHIRMTEN KABELS ; ENTSPRECHENDES KABEL MIT EINER SCHIRMUNG**
METHOD OF CREATING A SHIELD CONNECTION OF A SHIELDED CABLE; CORRESPONDING CABLE HAVING SHIELDING
PROCÉDÉ DE RÉALISATION D'UN RACCORDEMENT DU BLINDAGE D'UN CÂBLE BLINDÉ ; CÂBLE CORRESPONDANT MUNI D'UN BLINDAGE

(30) Priorität: 13.11.2017 DE 102017126530
(43) Veröffentlichungstag der Anmeldung: 19.08.2020
(73) Patentinhaber: Auto-Kabel Management GmbH, 79688 Hausen i.W. (DE)
(72) Erfinder: SCHARKOWSKI, Oliver, 79669 Zell im Wiesental (DE)
(74) Vertreter: Cohausz & Florack
(86) Internationale Anmeldenummer: PCT/EP2018/072086
(87) Internationale Veröffentlichungsnummer: WO 2019/091613

(56) Entgegenhaltungen:
- DE-A1-102007 021 846
- DE-A1-102010 003 599
- US-A1- 2001 016 459
- US-A1- 2014 326 501
- US-B1- 6 229 125

## Beschreibung

Der Gegenstand dieser Erfindung betrifft ein Verfahren zum Erstellen einer Schirmanbindung eines geschirmten Kabels sowie ein Kabel.

Durch den zunehmenden Anteil an Hybrid-und Elektrofahrzeugen und der damit einhergehenden Elektrifizierung des Antriebsstrangs wachsen die Anforderungen an sogenannte Hochvoltleitungen. Hochvoltleitungen sind Leitungen mit großen Kabelquerschnitten, die eine Stromtragfähigkeit von mehreren 100A bei gleichzeitiger Durchschlagfestigkeit von mehreren 100 V bis einigen 1000V haben. Durch die hohen Spannungen und Ströme in den Hochvoltleitungen ist die elektromagnetische Strömung der Leitung eine wesentliche Komponente. Die elektromagnetische Verträglichkeit der stromführenden Leitungen in Hochvoltanwendungen muss gegeben sein und eine Beeinflussung anderer elektrischer Komponenten muss sicher vermieden werden.

Die elektromagnetische Strahlung wird durch eine den Leiter des Kabels umgebende Schirmung geschirmt. Die Schirmung muss dabei entlang der stromführenden Komponenten durchgängig mit einem gleichen elektrischen Potential, insbesondere Masse, kontaktiert sein, um eine sichere Abschirmung der elektromagnetischen Strahlung zu gewährleisten. Dies bedeutet aber auch, dass nicht nur entlang des Kabelstrangs die Schirmung intakt sein muss, sondern auch an Übergängen zwischen zwei Kabeln und bei Einführungen von Kabeln in Gehäuse oder dergleichen. Solche Kabeleinführungen müssen eine sichere Schirmkontaktierung gewährleisten. Da die Schirmung in der Regel aus Folien und/oder Geflecht ist, ist die Kontaktierung mit anderen Schirmungen prozesstechnisch aufwändig. Aus diesem Grunde wird bereits vorgeschlagen, die Schirmung mit einer Hülse zu kontaktieren und die Hülse dann als Schirmkontaktierung zu verwenden.

Zur Kontaktierung der Hülse an die Schirmung sind verschiedene Techniken bekannt, wie sie beispielsweise in der DE 10 2007 051 836 A1 oder DE 10 2002 60 897 B4 beschrieben sind. Die dort beschriebenen Verbindungsverfahren sind jedoch mit einem komplexen Fertigungsaufwand verbunden. Bekannte Verfahren beruhen häufig auf einem Form- und/oder Kraftschluss, wobei die Langzeitstabilität dieser Verbindungen fraglich ist. Gerade in automotiven Anwendungen, bei denen die Verbindungen extremen Umweltbedingungen ausgesetzt sind, insbesondere mechanischen Schwingungen als auch elektrochemischen Angriffen durch Elektrolyte, ist eine langzeitstabile Kontaktierung zwischen Schirm und Hülse gewünscht.

Die Veröffentlichung US 2001/0016459 A1 bezieht sich insbesondere auf ein Verfahren und eine Vorrichtung zur Bearbeitung metallischer Werkstücke durch eine gepulste magnetische Energie.

Die Veröffentlichung US 2014/326501 A1 (Basis für den Oberbegriff der Ansprüche 1 und 8) bezieht sich auf ein elektrisches Kabel und auf ein Verfahren zur Herstellung eines elektrischen Kabels sowie auf eine Schweißvorrichtung zur Herstellung eines elektrischen Kabels. Der Gegenstand bezieht sich insbesondere auf die Möglichkeit der Kontaktierung von elektrischen Abschirmungen in Hochspannungskabeln, insbesondere in Hochspannungskabeln im Bereich von Hybrid- oder Elektrofahrzeugen.

Die Veröffentlichung DE 10 2007 021 846 A1 betrifft eine Verbindung zwischen einer starren Rohrleitung und einem flexiblen Leitungselement sowie ein Verfahren zur Herstellung einer solchen Verbindung.

Die Veröffentlichung DE 10 2010 003 599 A1 betrifft insbesondere die Kontaktierung von Kabeln umfassend Leichtmetalllitzen, wie beispielsweise Aluminiumlitzen. Die Veröffentlichung ist aber auch auf andere Litzenmaterialien, wie beispielsweise Magnesium- und Kupferlitzen oder auf Litzen aus Legierungen eines oder mehrerer der zuvor genannten, oder anderer geeigneter Materialen übertragbar. Derartige Kabel werden vor allem im Kraftfahrzeugbau verwendet, um elektrische Verbraucher mit elektrischer Energie zu versorgen. Ebenso werden derartige Kabel für die Erdung von elektrischen Systemen verwendet. Neben dem Verfahren zur Kabelkonfektionierung betrifft die vorliegende Erfindung auch ein konfektioniertes Kabel.

Dem Gegenstand lag die Aufgabe zugrunde, eine Schirmanbindung zur Verfügung zu stellen, welche langzeitstabil ist und prozesssicher herstellbar ist, insbesondere unter Einhaltung geringer Taktzeiten bei der Herstellung.

Diese Aufgabe wird durch ein Verfahren nach Anspruch 1 sowie ein Kabel nach Anspruch 8 gelöst.

Bei dem gegenständlichen Verfahren wird eine Hülse auf eine Schirmung eines Kabels aufgeschoben.

Das Kabel ist in der Regel aus einem Innenleiter, auch Seele genannt, einer inneren Isolation, einer Schirmung und einer äußeren Isolation aufgebaut. Der Innenleiter kann dabei als Flach- oder Rundleiter gebildet sein und entweder aus Vollmaterial monolithisch oder aus einer Litze gebildet sein. Die innere Isolation isoliert den Innenleiter gegenüber der Schirmung.

Die Schirmung wird freigelegt und unmittelbar auf die Schirmung wird die Hülse aufgeschoben. Die Hülse kann dabei einteilig oder auch mehrteilig sein, und insbesondere ein Oberteil und ein Unterteil aufweisen. Die Hülse kann auf das Kabel bzw. die Schirmung aufgesetzt oder aufgeschoben werden.

Nachdem die Hülse auf die Schirmung aufgeschoben/aufgesetzt wurde, wird die Hülse temporär an der Schirmung fixiert, beispielsweise mittels eines Haltearms oder dergleichen. Eine Fixierung kann auch dadurch gewährleistet sein, dass die Hülse in einer Presspassung auf die Schirmung aufgeschoben wurde. Insbesondere die innere Isolation ist elastisch verformbar und ermöglicht somit ein Aufschieben der Hülse unter gleichzeitiger Deformation der Isolation, so dass die Hülse durch die Rückstellkraft der Isolation an der Schirmung verliersicher gehalten ist.

Zum einfachen Aufschieben der Hülse auf die Schirmung kann die Hülse eine Öffnung aufweisen, die sich zu einem stirnseitigen Ende der Hülse aufweitet. Somit kann die Hülse mit dem aufgeweiteten Ende auf die Schirmung aufgeschoben werden und während des Aufschiebens verpresst die Hülse die Schirmung an der Isolation und wird dadurch verliersicher an der Schirmung gehalten.

Das Kabel samt Hülse wird anschließend mit einem entsprechenden Werkzeug in eine Magnetimpulsschweißspule eingeführt.

Sobald das Kabel samt Hülse in der Magnetimpulsschweißspule positioniert ist, wird die Magnetimpulsschweißspule mit einem elektrischen Impuls bestromt. Der Impuls hat eine derartige Stromstärke, dass die auf die Hülse wirkende Lorentzkraft durch den in der Hülse induzierten Wirbelstrom ausreichend ist, die Hülse plastisch zu verformen und insbesondere stoffschlüssig auf der Schirmung zu fügen.

Durch die hohe Verformgeschwindigkeit durch den sehr kurzen Impuls kommt es zu einem Kaltverschweißen zwischen dem Material der Schirmung und dem Material der Hülse. Gemäß der Erfindung ist die Innenwand der Hülse stoffschlüssig mit der Schirmung gefügt.

In einem Längsschnitt der Fügezone zwischen Hülse und Schirmung zeigt sich insbesondere ein wellenförmiges Schweißbild. Es entstehen intermetallische Kontaktzonen zwischen der Metallhülse und dem Metall der Schirmung.

Zum Aufschieben der Hülse auf die Schirmung wird vorgeschlagen, dass zunächst in einem Bereich eine äußere Isolation des Kabels entfernt wird und anschließend die Hülse auf diesen Bereich aufgeschoben wird. Durch die Entfernung der Isolation wird die Schirmung freigelegt, so dass die Hülse unmittelbar auf die Schirmung aufgesetzt werden kann. Für den Fall, dass der Bereich in dem die Isolation entfernt wird, zwischen zwei stirnseitigen Enden des Kabels liegt und beidseitig von einer äußeren Isolation umgeben ist, ist die Hülse bevorzugt mehrteilig und kann von außen radial auf die Schirmung aufgesetzt werden. Hierbei können die einzelnen Teile der Hülse miteinander durch eine entsprechende mechanische Gestaltung verrasten, so dass die Teile der Hülse verliersicher an der Schirmung angeordnet sind, bevor die Hülse mit der Schirmung stoffschlüssig gefügt wird.

Der Impuls mit dem die Magnetimpulsschweißspule bestromt wird hat eine Dauer von weniger als 1 Sekunde, insbesondere weniger als 0,5 Sekunden, bevorzugt in etwa 0,3 Sekunden oder weniger. Der Impuls hat dabei bevorzugt eine Dauer die zumindest länger ist als 0,1 Sekunde.

Für die kurze Impulsdauer wird ein Energiespeicher in einem Impulsgenerator sehr schnell entladen. Dies führt zu einer großen Stromstärke, da die durch den Speicher gespeicherte Ladung in einem sehr kurzen Zeitraum durch die Magnetimpulsschweißspule fließt. Insbesondere wird vorgeschlagen, dass der Impuls eine Stromstärke von zumindest 10kA, bevorzugt zumindest 100kA aufweist. Hierzu ist in dem Impulsgenerator bevorzugt zumindest ein Kondensator vorgesehen, dessen Ladung impulsartig entladen wird. Die Spannung kann beispielsweise bei 400 V liegen.

Die hohen Stromstärken in der Magnetimpulsschweißspule führen zu einem großen Wirbelstrom in der Hülse, welcher seinerseits eine in das Innere der Spule gerichtete Lorentzkraft auf die Hülse bewirkt. Diese Lorentzkraft führt zu einer dauerhaften, plastischen Verformung der Hülse innerhalb kürzester Zeit, so dass ein Kaltverschweißen zwischen der Hülse und der Schirmung gewährleistet ist.

Die Magnetimpulsschweißspule ist bevorzugt eine Ringspule. Um sicherzustellen, dass die Hülse umlaufend auf der Schirmung mit in etwa gleicher Energie verschweißt wird, wird vorgeschlagen, dass das Kabel samt Hülse konzentrisch mit der Spulenachse der Ringspule in die Magnetimpulsschweißspule eingeführt wird. Dies führt dazu, dass die Lorentzkraft entlang des Umfanges der Hülse möglichst gleich ist. Hierdurch wird eine möglichst gleichförmige plastische Verformung der Hülse und somit eine möglichst gleichförmige stoffschlüssige Fügung der Hülse entlang des Umfanges der Innenfläche der Hülse an der Schirmung gewährleistet.

Wie bereits erläutert, wird die Hülse durch den Impuls kalt umgeformt. Durch die schnelle Kaltumformung entsteht in der Schweißzone nur eine sehr geringe Temperatur, was vorteilhaft sein kann. Durch den Impuls und die dadurch bewirkte Lorentzkraft wird die Fließspannung des Werkstoffes der Hülse überschritten. Die Hülse wird somit berührungslos kaltverformt. Es erfolgt eine Hochgeschwindigkeitskollision zwischen der Innenfläche der Hülse und der Schirmung, so dass fast ohne Erwärmung eine stoffschlüssige Verbindung zwischen der Hülse und der Schirmung erzielt wird. Bevorzugt wird die äußere Isolation des Kabels an einem stirnseitigen Ende des Kabel entfernt und die Hülse anschließend von dem stirnseitigen Ende aus auf das Kabel bzw. die Schirmung aufgeschoben.

Eine besonders gute Verbindung zwischen Hülse und Schirmung wird dann erreicht, wenn Hülse und Schirmung aus einem gleichen Metall gebildet sind. Insbesondere eignen sich Nichteisenmetalle, wie beispielsweise Aluminium oder Kupfer sowie die jeweiligen Legierungen hiervon. Wichtig ist, dass das Material der Hülse eine hohe Leitfähigkeit hat. Hierdurch werden in der Hülse große Wirbelströme erzeugt, welche dazu führen, dass die auf die Hülse wirkende Lorentzkraft groß ist.

Der Innenleiter hat bevorzugt einen runden oder rechteckigen Querschnitt und kann somit ein rundes Kabel oder ein Flachkabel bilden. Der Innenleiter ist insbesondere als Litzenleiter oder als einstückiger Leiter gebildet.

Die Schirmung ist bevorzugt ein Metallgeflecht und/oder eine Metallfolie.

Zur Anpassung der Hülse an eine Kabeleinführung wird vorgeschlagen, dass die Hülse einen Außenumfang hat, der an eine Kabeleinführung angepasst ist. Dies kann dazu führen, dass die Hülse einen Öffnungsquerschnitt und einen Außenquerschnitt aufweist, wobei der Öffnungsquerschnitt von dem Außenquerschnitt verschieden ist. Der Öffnungsquerschnitt entspricht in etwa dem Querschnitt von innerer Leitung, innerer Isolation und Schirmung. Dies führt dazu, dass die Hülse mit dem Öffnungsquerschnitt auf die Schirmung aufgeschoben werden kann. An hier von abweichender Außenquerschnitt kann dafür Sorge tragen, dass nach dem stoffschlüssigen Fügen die Hülse mit einer Kabeleinführung korrespondiert und eine gute Schirmanbindung gewährleitet ist.

Nachfolgend wird der Gegenstand anhand einer Ausführungsbeispiele zeigenden Zeichnung näher erläutert. In der Zeichnung zeigen:
- Fig. 1: ein Kabel samt Hülse,
- Fig. 2: ein in eine Magnetimpulsspule eingeführtes Kabel;
- Fig. 3: ein durch einen Magnetimpuls mit einer Schirmung verschweißte Hülse.

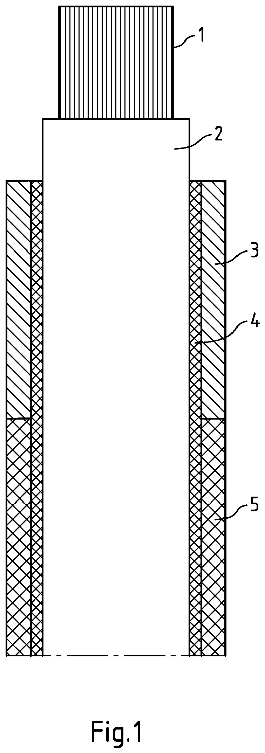

Fig. 1 zeigt ein Kabel mit einem Innenleiter 1. Der Innenleiter 1 kann als Litze oder aus Vollmaterial gebildet sein. Der Innenleiter 1 ist bevorzugt aus Kupfer oder einer Legierung hiervon, kann jedoch auch als Aluminium oder einer Legierung hiervon gebildet sein. Der Querschnitt des Innenleiters 1 ist bevorzugt rund oder rechteckig.

Den Innenleiter 1 umgebend ist eine Primärisolation 2 vorgesehen. Die Primärisolation 2 ist aus einem elektrisch isolierenden Werkstoff gebildet.

Um die Primärisolation 2 ist ein Schirm 4 gewickelt. Der Schirm 4 kann als Metallfolie oder Metallgeflecht oder einer Kombination daraus gebildet sein.

Die Schirmung 4 umgibt eine Sekundärisolation 5. Die Sekundärisolation 5 kann aus dem gleichen Material gebildet sein wie die Primärisolation 2.

Zu erkennen ist, dass an dem stirnseitigen Ende des Kabels die Sekundärisolation 5 von der Schirmung 4 entfernt wurde. Freigelegt ist die Schirmung 4 in einem stirnseitigen Bereich. Auf diesen Bereich kann die Hülse 3 aufgeschoben werden. Die Hülse 3 hat dabei bevorzugt einen Innendurchmesser, der den Außendurchmesser der Primärisolation 2 samt Schirm 4 entspricht.

Die Hülse 3 ist bevorzugt aus dem gleichen Material gebildet, wie der Schirm 4. Es eignen sich hier insbesondere Kupfer bzw. Aluminium sowie Legierungen hiervon.

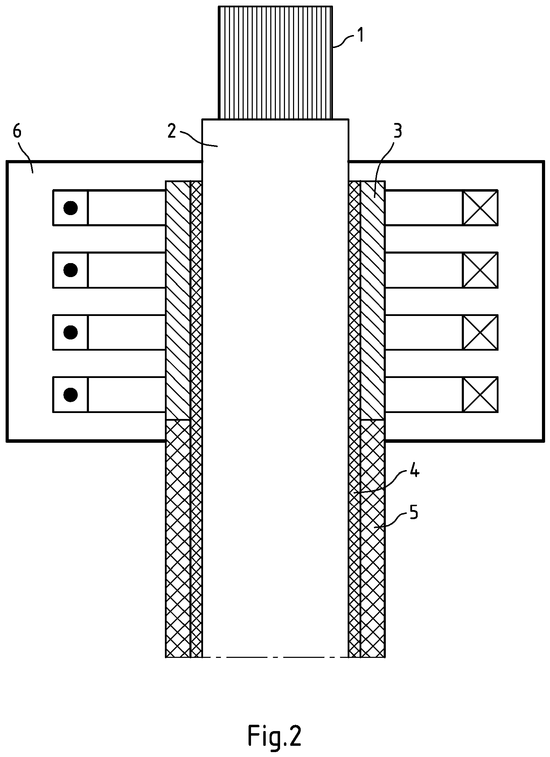

Nachdem die Hülse 3 auf den Schirm 4 aufgeschoben wurde, wird das Kabel durch eine Zuführeinrichtung in einer Magnetimpulsspule 6, wie in der Fig. 2 gezeigt, positioniert. Die Magnetimpulsspule 6 verfügt über eine Mehrzahl an Wicklungen und ist insbesondere als Ringspule gebildet. Die Wicklungen sind umlaufend um das Kabel. Das Kabel ist vorzugsweise mit seiner Längsachse kollinear mit der Längsachse der Magnetimpulsspule 6.

Zu erkennen ist, dass das Kabel mit der Hülse 3 im Inneren der Magnetimpulsspule 6 positioniert ist.

Über einen Impulsgenerator, der insbesondere zumindest einen Kondensator und einen ohmschen Widerstand sowie einen Schalter aufweist, lässt sich ein kurzer Stromimpuls auf die Magnetimpulsspule 6 übertragen. Hierzu wird die Magnetimpulsspule 6 über den Kondensator und den Widerstand kurzgeschlossen. Dadurch entlädt sich der Kondensator und die gespeicherte Ladung fließt sehr schnell durch die Magnetimpulsspule 6. Dabei entstehen Ströme von bis zu einigen 100kA.

Die in der Spule 6 fließenden Ströme bewirken einen Wirbelstrom in der Hülse 6, Dadurch wird eine Lorentzkraft auf die Hülse 3 ausgeübt, die in Richtung des Inneren des Kabels wirkt.

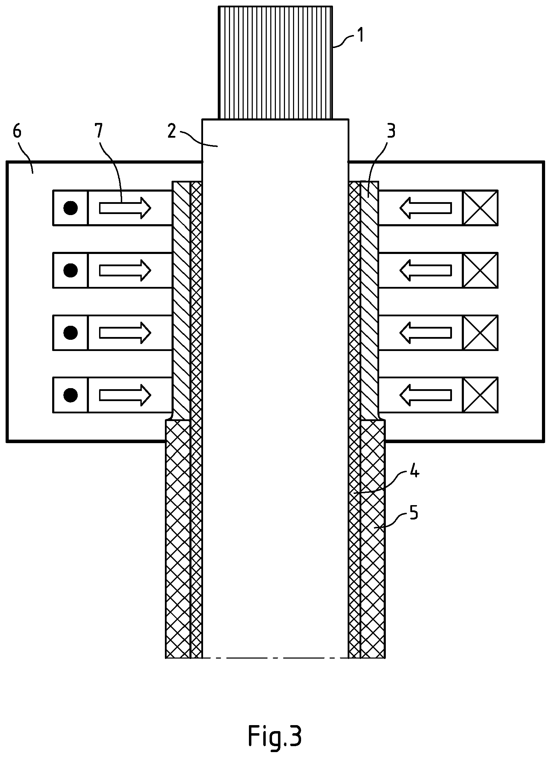

Durch diese Lorentzkraft erfolgt ein Kaltumformen der Hülse 3, wie in der Fig. 3 gezeigt. Die Lorentzkraft wirkt in Richtung 7 auf die Hülse 3 und die Hülse 3 wird in Bruchteilen einer Sekunde plastisch verformt und auf den Schirm 4 aufgepresst. Durch die hohe Beschleunigung entsteht eine intermetallische Verbindung zwischen der Innenwand der Hülse 3 und dem Schirm 4. Somit ist die Hülse 3 mit dem Schirm 4 nicht nur form- und kraftschlüssig verbunden, sondern auch stoffschlüssig gefügt.

Im Anschluss wird das Kabel aus der Magnetimpulsspule 6 entfernt und das nächste Kabel kann eingelegt werden.

Die Taktzeit ist sehr kurz, da das Verschweißen in kürzester Zeit, insbesondere in weniger als 1 Sekunde erfolgt. Der Impulsgenerator kann geladen werden, während das Kabel aus der Magnetimpulsspule 6 entfernt wird und ein neues Kabel eingelegt wird. Diese Zeit kann ausreichend sein, den Impulsgenerator bzw. dessen Kondensatoren mit ausreichend Ladung zu beladen, so dass im nächsten Arbeitsschritt erneut eine ausreichende Lorentzkraft auf die Hülse 3 wirkt.

Mit Hilfe des gezeigten Verfahrens lassen sich prozesssicher langzeitstabile Verbindungen zwischen Hülsen und Schirmungen herstellen.

## Patentansprüche

1. Verfahren zum Erstellen einer Schirmanbindung eines geschirmten Kabels mit den Schritten:
- Aufschieben einer Hülse (3) auf eine Schirmung (4) eines Kabels, **gekennzeichnet durch**
- Einführen des Kabels samt Hülse (3) in eine Magnetimpulsschweißspule,
- Bestromen der Magnetimpulsschweißspule mit einem Impuls derart, dass eine Innenwand der Hülse (3) mit der Schirmung (4) stoffschlüssig gefügt wird.

2. Verfahren nach Anspruch 1,
**dadurch gekennzeichnet,**
- **dass** in einem Bereich eine äußere Isolation des Kabels entfernt wird und dass die Hülse (3) auf diesen Bereich aufgeschoben wird.

3. Verfahren nach einem der vorangehenden Ansprüche,
**dadurch gekennzeichnet,**
- **dass** der Impuls eine Dauer von weniger als eine Sekunde hat.

4. Verfahren nach einem der vorangehenden Ansprüche,
**dadurch gekennzeichnet,**
- **dass** der Impuls eine Stromstärke von zumindest 10kA, bevorzugt mehr als 100kA aufweist.

5. Verfahren nach einem der vorangehenden Ansprüche,
**dadurch gekennzeichnet,**
- **dass** die Magnetimpulsschweißspule eine Ringspule ist und dass das Kabel samt Hülse (3) konzentrisch mit der Spulenachse der Ringspule in die Magnetimpulsschweißspule eingeführt wird.

6. Verfahren nach einem der vorangehenden Ansprüche,
**dadurch gekennzeichnet,**
- **dass** die Hülse (3) durch den Impuls kaltumgeformt wird.

7. Verfahren nach einem der vorangehenden Ansprüche,
**dadurch gekennzeichnet,**
- **dass** die äußere Isolation des Kabels an einem stirnseitigen Ende des Kabels entfernt wird.

8. Kabel mit
- einem Innenleiter (1),
- einer den Innenleiter (1) umgebenden inneren Isolation,
- einer die innere Isolation umgebenden Schirmung (4),
- einer die Schirmung (4) umgebenden äußeren Isolation,
- einer auf einen von der äußeren Isolation befreiten Bereich aufgeschobenen, die Schirmung (4) umgebenden Hülse (3),
**dadurch gekennzeichnet,**
- **dass** die Schirmung (4) mit einer Innenwand der Hülse (3) mittels Magnetimpulsschweißen stoffschlüssig verschweißt sind.

9. Kabel nach Anspruch 8,
**dadurch gekennzeichnet,**
- **dass** die Hülse (3) und die Schirmung (4) aus einem gleichen Metall gebildet sind, insbesondere aus Aluminium oder Legierungen davon oder Kupfer oder Legierungen davon.

10. Kabel nach Anspruch 8 oder 9,
**dadurch gekennzeichnet,**
- **dass** zumindest der Innenleiter (1) eine runden oder einen rechteckigen Querschnitt hat.

11. Kabel nach einem der vorangehenden Ansprüche,
**dadurch gekennzeichnet,**
- **dass** die Schirmung (4) aus einem Metallgeflecht und/oder einer Metallfolie gebildet ist.

12. Kabel nach einem der vorangehenden Ansprüche,
**dadurch gekennzeichnet,**
- **dass** die Hülse (3) einen Öffnungsquerschnitt und einen Außenquerschnitt aufweist, wobei der Öffnungsquerschnitt von dem Außenquerschnitt verschieden ist.

## Claims

1. Method for establishing a shield connection of a shielded cable comprising the steps of:
- pushing a sleeve (3) onto a shield (4) of a cable,
**characterized in that**
- inserting the cable together with the sleeve (3) into a magnetic pulse welding coil,
- energizing the magnetic pulse welding coil with a pulse in such a way that an inner wall of the sleeve (3) is joined with the shield (4) in a material bond.

2. Method according to claim 1,
**characterized in that**
- an outer insulation of the cable is removed in one area and the sleeve (3) is pushed onto this area.

3. Method according to one of the preceding claims,
**characterized in that**
- the pulse has a duration of less than one second.

4. Method according to one of the preceding claims,
**characterized in that**
- the pulse has a current amplitude of at least 10kA, preferably more than 100kA.

5. Method according to one of the preceding claims,
**characterized in that**
- the magnetic pulse welding coil is a toroidal coil and the cable with the sleeve (3) is inserted into the magnetic pulse welding coil concentrically with the coil axis of the toroidal coil.

6. Method according to one of the preceding claims,
**characterized in that**
- the sleeve is cold-formed by the pulse.

7. Method according to one of the preceding claims,
**characterized in that**
- the outer insulation of the cable is removed at one front-end of the cable.

8. Cable with
- an inner conductor (1),
- an inner insulation surrounding the inner conductor (1),
- a shield (4) surrounding the inner insulation,
- an outer insulation surrounding the shield (4),
- a sleeve (3) surrounding the shield (4) pushed onto an area freed from the outer insulation,
**characterized in that**
- the shield (4) is welded in a material bond to the sleeve (3) by means of magnetic pulse welding.

9. Cable according to claim 8,
**characterized in that**
- the sleeve (3) and the shield (4) are made of the same metal, in particular from aluminium or alloys thereof or from copper or alloys thereof.

10. Cable according to claim 8 or 9,
**characterized in that**
- at least the inner conductor (1) has a round or a rectangular cross-section.

11. Cable according to one of the preceding claims,
**characterized in that**
- the shield (4) is formed from a metal braid and/or a metal foil.

12. Cable according to one of the preceding claims,
**characterized in that**
- the sleeve (3) has an opening cross-section and an outer cross-section, wherein the opening cross-section is different from the outer cross-section.

## Revendications

1. Méthode de création d'une connexion de blindage d'un câble blindé, comprenant les étapes :
- Glisser une douille (3) sur un blindage (4) d'un câble,
**caractérisé par**
- insérer du câble avec la douille (3) dans une bobine de soudage par impulsion magnétique,
- exciter la bobine de soudage par impulsion magnétique avec une décharge de telle sorte qu'une paroi intérieure de la douille (3) soit reliée au blindage (4) par liaison de matière.

2. Méthode selon la revendication 1,
**caractérisé en**
- **ce qu'**une isolation extérieure du câble est dénudée dans une région, et **en ce que** la douille (3) est poussée sur cette région.

3. Méthode selon l'une des revendications précédentes,
**caractérisé en**
- **ce que** la décharge a une durée de moins d'une seconde.

4. Méthode selon l'une des revendications précédentes,
**caractérisé en,**
- **ce que** la décharge a une intensité de courant d'au moins 10 kA, de préférence supérieure à 100 kA.

5. Méthode selon l'une des revendications précédentes,
**caractérisé en**
- **ce que** la bobine de soudage par impulsion magnétique est une bobine toroïdale et que le câble avec la douille (3) est inséré dans la bobine de soudage par impulsion magnétique concentriquement à l'axe de la bobine toroïdale.

6. Méthode selon l'une des revendications précédentes,
**caractérisé en**
- **ce que** la douille (3) est formé à froid par la décharge.

7. Méthode selon l'une des revendications précédentes,
**caractérisé en**
- **ce que** l'isolation extérieure du câble est dénudée à l'extrémité frontale du câble.

8. Câble ayant
- un conducteur intérieur (1),
- une isolation intérieure entourant le conducteur intérieur (1),
- un blindage (4) entourant l'isolation intérieure,
- une isolation extérieure entourant le blindage (4),
- une douille (3) poussé sur une zone dénudée de l'isolation extérieure et entourant le blindage (4),
**caractérisé en**
- **ce que** le blindage (4) est soudé à une paroi intérieure de la douille (3) au moyen de soudage par impulsion magnétique.

9. Le câble selon la revendication 8,
**caractérisé en**
- **ce que** la douille (3) et le blindage (4) sont formés du même métal, en particulier d'aluminium ou d'un de ses alliages ou de cuivre ou d'un de ses alliages.

10. Câble selon la revendication 8 ou 9,
**caractérisé en**
- **ce qu'**au moins le conducteur intérieur (1) a une section transversale ronde ou rectangulaire.

11. Le câble selon l'une des revendications précédentes,
**caractérisé en**
- **ce que** le blindage (4) est formé d'un treillis métallique et/ou d'une feuille métallique.

12. Le câble selon l'une des revendications précédentes,
**caractérisé en**
- **ce que** la douille (3) a une section transversale d'ouverture et une section transversale extérieure, la section transversale de l'ouverture étant différente de la section transversale extérieure.
